# EUROPÄISCHE PATENTSCHRIFT

(11) **EP 1 770 726 B1**
(45) Veröffentlichungstag und Bekanntmachung des Hinweises auf die Patenterteilung: **21.04.2010**
(21) Anmeldenummer: 06119374.4
(22) Anmeldetag: 23.08.2006
(51) Int. Cl.: H01G 4/33, H01G 4/40, H01L 21/02, H01L 27/13

(54) **MIM-Kondensator sowie zugehöriges Herstellungsverfahren**
MIM-capacitor and corresponding method of manufacturing
Condensateur MIM et méthode de fabrication corrrespondante

(30) Priorität: 30.09.2005 DE 102005047111
(43) Veröffentlichungstag der Anmeldung: 04.04.2007
(73) Patentinhaber: Infineon Technologies AG, 81669 München (DE)
(72) Erfinder: Engelhardt, Manfred, 83620 Feldkirchen-Westerham (DE); Stich, Andreas, 82031 Grünwald (DE); Schindler, Guenther, 80802 München (DE); Schrenk, Michael, 86911 Diessen am Ammersee (DE)
(74) Vertreter: Kindermann, Peter

(56) Entgegenhaltungen:
- JP-A- 2005 142 337
- JP-A- 2006 019 379
- US-A1- 2003 001 190
- US-A1- 2003 027 385
- US-A1- 2005 067 701
- US-A1- 2005 121 744
- US-B1- 6 255 187
- US-B1- 6 759 703

## Beschreibung

Die vorliegende Erfindung bezieht sich auf einen MIM-Kondensator sowie ein zugehöriges Herstellungsverfahren und insbesondere auf einen Dual-Damascene-fähigen MIM-Kondensator.

Kondensatoren werden in einer Vielzahl von Anwendungsfällen benötigt, wie beispielsweise elektronischen Filtern, A/D-Wandlern, Steuerschaltungen und insbesondere in analogen Schaltungen.

In der Halbleitertechnik, bei der eine Vielzahl von unterschiedlichen Funktionen auf einem einzigen Chip integriert ist, werden daher zunehmend sogenannte MIM-caps bzw. MIM-Kondensatoren (Metall-Isolator-Metall) eingesetzt. Ein derartiger MIM-Kondensator ist ein spezieller Typ von Kondensatoren, bei dem zwei metallische Platten parallel zur Halbleiterwafer-Oberfläche ausgebildet sind und nur von einem Kondensatordielektrikum getrennt werden.

Die Herstellung von herkömmlichen MIM-Kondensatoren ist jedoch sehr aufwändig, da zum Teil bis zu drei Lithographieschritte erforderlich sind, um diese herzustellen. Ferner weisen herkömmliche MIM-Kondensatoren oftmals einen sehr hohen Leckstrom auf sowie eine unerwünscht hohe extrinsische Defektdichte, die sich auf Grund des Einflusses der üblicherweise verwendeten Cu-Elektroden ergibt.

Aus der Druckschrift US 2004/0224474 A1 ist ein MIM-Kondensator sowie ein zugehöriges Herstellungsverfahren gemäß dem Stand der Technik bekannt, bei dem in einem ersten Zwischendielektrikum eine erste Kondensatorelektrode ausgebildet ist, anschließend eine elektrisch leitende Diffusions-Barrierenschicht an der Oberfläche der Kondensatorelektrode selektiv ausgebildet wird, ferner ein zweites Zwischendielektrikum ausgebildet wird und darin eine Öffnung zum Freilegen eines Teilbereichs der Diffusions-Barrierenschicht geätzt wird. Daraufhin wird ein sogenanntes "High-k"-Kondensatordielektrikum ganzflächig abgeschieden und an deren Oberfläche zunächst eine Cu-Keimschicht und darauf ein Cu-Füllmaterial zum Auffüllen der Öffnung eingebracht. Nach einem Planarisierungsschritt wird das eingebrachte Cu mit einer weiteren Diffusions-Barrierenschicht abgeschlossen und es kann ein weiteres Zwischendielektrikum für nachfolgende Leitbahnebenen ausgebildet werden.

Obwohl man bei einem derartigen MIM-Kondensator bereits einen stark verringerten Leckstrom bei einer verringerten extrinsischen Defektdichte erhält, ist das Verfahren kostenintensiv und es ergeben sich insbesondere für nachfolgende Prozessschritte erhebliche Probleme.

Insbesondere können bei den herkömmlichen MIM-Kondensatoren keine kostengünstigen Dual-Damascene-Verfahren zur Ausbildung von weitergehenden Leitbahnen und Kontaktierungen ohne zusätzliche Prozessschritte durchgeführt werden.

Aus der Druckschrift US-B1-6 759 703 sind ferner ein MIM-Kondensator sowie ein zugehöriges Herstellungsverfahren bekannt, wobei eine erste Kondensatorelektrode in der Oberfläche eines ersten Zwischendielektrikums ausgebildet ist. Eine erste elektrisch leitende Diffusions-Barrierenschicht ist an der Oberfläche der ersten Kondensatorelektrode und Teilbereichen des Zwischendielektrikums ausgebildet. Ein zweites Zwischendielektrikum befindet sich auf dem ersten Zwischendielektrikum und besitzt eine Öffnung zum Freilegen von zumindest einem Teil der ersten Diffusions-Barrierenschicht. Ein Kondensatordielektrikum ist hierbei auf der Diffusions-Barrierenschicht und den Seitenwänden der Öffnung ausgebildet und eine zweite Kondensatorelektrode ist an der Oberfläche des Kondensatordielektrikums ausgebildet. Die Kosten für derartige MIM-Kondensatoren sind maskenbedingt sehr hoch.

Aus der weiteren Druckschrift US 2003/027385 A1 sind ein herkömmlicher MIM-Kondensator sowie ein zugehöriges Herstellungsverfahren bekannt, wobei die zweite elektrisch leitende Diffusions-Barrierenschicht ausschließlich als zweite Kondensatorelektrode verwendet wird.

Aus der Druckschrift US 2005/0121744 A1 sind ein MIM-Kondensator sowie ein zugehöriges Herstellungsverfahren bekannt, wobei eine Vielzahl von Materialien für elektrisch leitende und isolierende Diffusions-Barrierenschichten offenbart sind, wie z.B. TiN, TaN, Ti/TaN usw.

Aus der Druckschrift JP 2005 142337 A sind ferner ein herkömmlicher MIM-Kondensator sowie ein zugehöriges Herstellungsverfahren bekannt, wobei nach dem Ausbilden einer Öffnung im Zwischendielektrikum auf dem Boden und an den Seitenwänden der Öffnung aufeinanderfolgend eine untere Elektrode, ein Kondensatordielektrikum und eine obere Elektrode ausgebildet werden.

Schließlich offenbart die Druckschrift US-B1-6 255 187 einen selbstjustierten Stapelkondensator sowie ein zugehöriges Herstellungsverfahren, wobei vergrabene Kontakte mittels Elektroplattierung in Öffnungen eines Dielektrikums ausgebildet werden. Hierbei werden insbesondere die verschiedenen Materialien für zu verwendende Diffusions-Barrierenschichten offenbart.

Der Erfindung liegt daher die Aufgabe zu Grunde einen MIM-Kondensator sowie ein zugehöriges Herstellungsverfahren zu schaffen, bei dem gute elektrische Eigenschaften erzielt werden und die Kosten verringert sind.

Erfindungsgemäß wird diese Aufgabe hinsichtlich des MIM-Kondensators durch die Merkmale des Patentanspruchs 1 und hinsichtlich des Herstellungsverfahrens durch die Maßnahmen des Patentanspruchs 10 gelöst.

Insbesondere durch das Ausbilden einer ersten elektrisch leitenden Diffusions-Barrierenschicht am Boden der Öffnung und die Verwendung einer zweiten Kondensatorelektrode, die ausschließlich aus einer zweiten elektrisch leitenden Diffusions-Barrierenschicht besteht, können die Herstellungskosten stark verringert werden, da erstmalig auch kostengünstige Standard-Dual-Damscene-Verfahren für nachfolgende Leitbahnebenen ohne zusätzliche Prozesschritte verwendet werden können. Die elektrischen Eigenschaften, welche sich insbesondere aus einer verringerten extrinsischen Defektdichte und einem geringen Leckstrom ergeben, sind weiterhin ausreichend hoch.

Insbesondere wenn die zweite Kondensatorelektrode eine Schichtdicke aufweist, die größer ist als eine Schichtdicke einer ersten elektrisch leitenden Diffusions-Barrierenschicht und kleiner ist als eine halbe Schichtdicke des zweiten Zwischendielektrikums, erhält man für die zweite Kondensatorelektrode eine ausreichende elektrische Leitfähigkeit.

Zur weiteren Verbesserung dieser Leitfähigkeit kann eine Vielzahl von Kontaktvias die zweite Kondensatorelektrode kontaktieren, wodurch die ohnehin vorhandene Prozessfolge für Kontaktvias zur Verbesserung einer elektrischen Leitfähigkeit des MIM-Kondensators herangezogen werden kann.

Ferner kann zwischen dem ersten Zwischendielektrikum und dem zweiten Zwischendielektrikum eine weitere elektrisch isolierende Diffusions-Barrierenschicht ausgebildet werden, wodurch sich ein nachfolgender Einsatz eines Dual-Damascene-Verfahrens stark vereinfachen lässt. Insbesondere bei Verwendung einer weiteren elektrisch isolierenden Diffusions-Barrierenschicht an der Oberfläche der zweiten Kondensatorelektrode kann ein gleichzeitiges Ausbilden von Kontaktvias für den MIM-Kondensator sowie für Leitbahnen im ersten Zwischendielektrikum mittels eines herkömmlichen Dual-Damascene-Verfahrens sehr einfach hergestellt werden.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
Figuren 1A bis 1G vereinfachte Schnittansichten zur Veranschaulichung von wesentlichen Verfahrensschritten zur Herstellung eines MIM-Kondensators gemäß einem Ausführungsbeispiel der Erfindung; und
Figur 2 eine vereinfachte Draufsicht zur Darstellung einer Kontaktierung gemäß dem Ausführungsbeispiel.

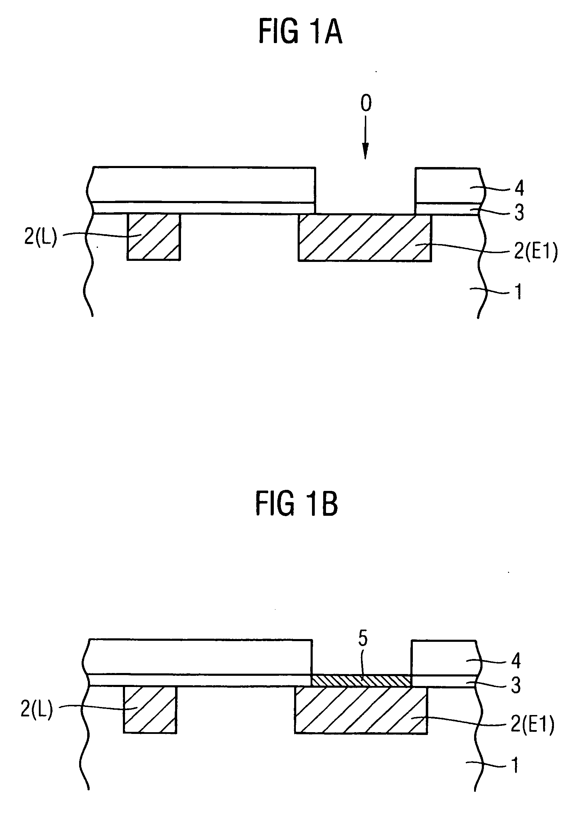

Die Figuren 1A bis 1G zeigen vereinfachte Schnittansichten zur Darstellung der wesentlichen Verfahrensschritte bei der Herstellung eines MIM-Kondensators gemäß einem Ausführungsbeispiel der vorliegenden Erfindung, wobei die dargestellten Schichtebenen sich in einer beliebigen Metallisierungsebene einer integrierten Schaltung befinden können.

Gemäß Figur 1A wird zunächst in der planaren Oberfläche eines ersten Zwischendielektrikums 1 eine erste Kondensatorelektrode El ausgebildet. Das erste Zwischendielektrikum 1 kann sich hierbei unmittelbar an der Oberfläche des Halbleiterwafers befinden oder in einer darüber liegenden Leitbahnebene ausgebildet sein. Ferner können auch alternative Trägersubstrate an Stelle des Halbleiterwafers verwendet werden.

Als Material für das Zwischendielektrikum wird beispielsweise ein Low-k-Material verwendet, wobei die Dielektrizitätskonstante von SiO₂ als Referenzwert betrachtet wird (k = 3,9).

Materialien mit einer Dielektrizitätskonstante unterhalb von 3,9 werden daher üblicherweise als sogenannte "Low-k"-Materialien bezeichnet, während Materialien mit höheren Dielektrizitätskonstanten als sogenannte "High-k"-Materialien bezeichnet werden.

Selbstverständlich können für das Zwischendielektrikum auch herkömmliche Oxide wie Silanoxid oder TEOS verwendet werden. Die Ausbildung der ersten Kondensatorelektrode E1 und einer ebenfalls im Zwischendielektrikum befindlichen Leitbahn L kann beispielsweise mit einem Single- oder Dual-Damascene-Verfahren im ersten Zwischendielektrikum 1 ausgebildet werden, wobei eine metallische Füllschicht 2 in vorher im Zwischendielektrikum 1 ausgebildeten Gräben abgeschieden wird. Die Füllschicht 2 weist üblicherweise an den Seitenwänden und am Boden der Gräben eine (nicht dargestellte) Diffusions-Barrierenschicht auf. Üblicherweise werden für diese metallische Füllschicht 2 eine TaN/Ta-Diffusions-Barrierenschichtstruktur sowie Cu als Füllmaterial verwendet.

Ferner kann an der planarisierten Oberfläche des ersten Zwischendielektrikums bzw. der darin ausgebildeten Leitbahn L und ersten Kondensatorelektrode E1 eine optionale erste elektrisch isolierende Diffusions-Barrierenschicht 3 ausgebildet werden. Diese auch als Abdeckschicht bezeichnete Diffusions-Barrierenschicht 3 wird beispielsweise mit einem chemischen Abscheideverfahren (CVD, Chemical Vapor Deposition) abgeschieden und kann Si₃N₄, SiC, SiCN oder ein sogenanntes Low-k-Material aufweisen.

Gemäß Figur 1A wird ferner entweder an der optionalen ersten elektrisch isolierenden Diffusions-Barrierenschicht 3 oder unmittelbar auf dem ersten Zwischendielektrikum 1 ein zweites Zwischendielektrikum 4 vorzugsweise ganzflächig ausgebildet. Dieses zweite Zwischendielektrikum besteht wie das erste Zwischendielektrikum vorzugsweise aus einem Low-k-Material oder einem Silanoxid oder TEOS. Eine Dicke dieses zweiten Zwischendielektrikums ist jedoch wesentlich geringer als die üblicherweise bei einem derartigen Herstellungsschritt abgeschiedenen Zwischendielektrika und ist insbesondere kleiner 2-3F, wobei F eine minimale, mittels fotolithographischer Verfahren herstellbare Strukturbreite eines jeweiligen Herstellungsverfahrens bzw. einer jeweiligen Technologie, darstellt.

Als nächstes wird mittels eines herkömmlichen Lithographieschritts die Fläche des MIM-Kondensators bestimmt und anschließend geätzt. Genauer gesagt wird eine Öffnung O im zweiten Zwischendielektrikum 4 und der optional vorhandenen ersten elektrisch isolierenden Diffusions-Barrierenschicht 3 zum Freilegen von zumindest einem Teil der ersten Kondensatorelektrode E1 ausgebildet. Beispielsweise können hierbei Plasmaätzverfahren oder reaktives Ionenätzen (RIE, Reactive Ion Etch) durchgeführt werden. Die Fläche der Öffnung O bestimmt hierbei im Wesentlichen die Kapazität des MIM-Kondensators.

Gemäß Figur 1B wird in einem nachfolgenden Schritt eine erste elektrisch leitende Diffusions-Barrierenschicht 5 selbstjustiert auf der ersten Kondensatorelektrode E1 ausgebildet. Genauer gesagt wird an der Oberfläche der durch die Öffnung O freigelegten ersten Kondensatorelektrode E1 eine elektrisch leitende Diffusions-Barrierenschicht 5 selektiv ausgebildet, wobei vorzugsweise ein stromloses Abscheideverfahren in einem nasschemischen Bad durchgeführt wird. Derartige Abscheideverfahren sind beispielsweise in der Druckschrift N. Petrov et al.: "Electrochemical study of the electroless deposition of Co (P) and Co (WP) Alloys", Journal of the Electrochemical Society, 149, Seiten 187 bis 194, 19. Februar 2002 beschrieben.

Mittels alternativer Verfahren können auch nachfolgende Materialien selbstjustiert und selektiv auf Kupfer aufgewachsen werden: Nickel-Wolfram-Phosphor, Nickel-Wolfram-Bor, Nickel-Wolfram-Phosphor-Bor, Nickel-Rhenium-Phosphor, Nickel-Rhenium-Bor, Nickel-Rhenium-Phosphor-Bor, Nickel-Molybdän-Phosphor, Nickel-Molybdän-Bor, Nickel-Molybdän-Phosphor-Bor, Nickel-Phosphor, Kobalt-Wolfram-Bor, Kobalt-Wolfram-Phosphor, Kobalt-Wolfram-Phosphor-Bor, Kobalt-Rhenium-Phosphor, Kobalt-Rhenium-Bor und Kobalt-Rhenium-Phosphor-Bor.

Diese elektrisch leitende Barrierenschicht 5 verhindert einerseits eine Diffusion des Metalls der Kondensatorelektrode E1 in andere Schichten und insbesondere in ein nicht dargestelltes Halbleitermaterial bzw. -substrat und sorgt darüber hinaus für ein gutes Interface zwischen der Kondensatorelektrode und dem Kondensatordielektrikum des MIM-Kondensators. Insbesondere lässt sich dadurch eine sehr homogene Dicke des Kondensatordielektrikums einstellen, da eine extrinsische Defektdichte wesentlich verringert wird. Die Dicke dieser selektiv ausgebildeten und damit selbstjustierten Diffusions-Barrierenschicht 5 beträgt ca. 10 bis 100 nm und ist von der jeweils verwendeten Technologie abhängig.

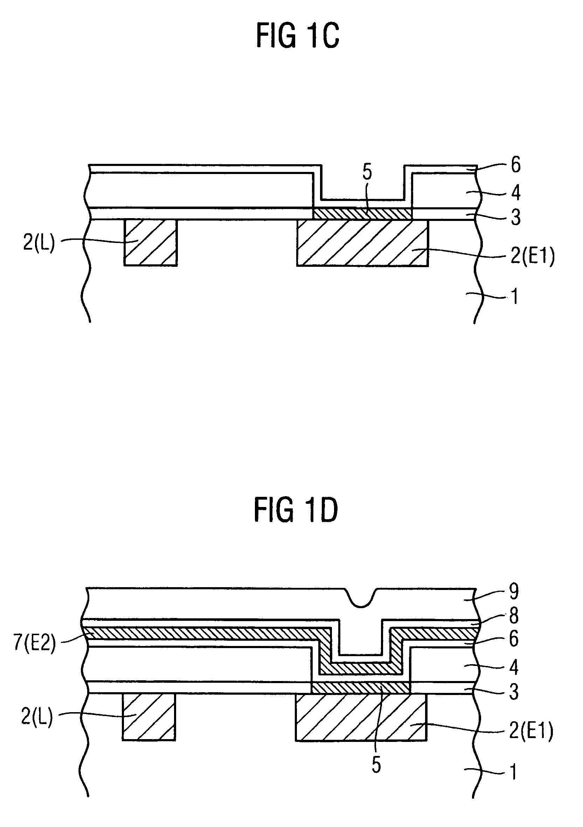

Gemäß Figur 1C erfolgt anschließend ein ganzflächiges Ausbilden eines Kondensatordielektrikums 6 an der Oberfläche der ersten elektrisch leitenden Diffusions-Barrierenschicht 5 und des zweiten Zwischendielektrikums 4. Genauer gesagt wird mittels eines CVD- oder ALD-Verfahrens (ALD, Atomic Layer Deposition) bei einer möglichst geringen Temperatur ein sogenanntes High-k-Dielektrikum mit einer möglichst geringen Dicke von 2 bis 50 nm abgeschieden. Eine typische Dicke, die insbesondere im Bereich der Kondensatorelektrode bzw. der darauf ausgebildeten Diffusions-Barrierenschicht 5 liegt, beträgt ca. 10 nm. Dieses Kondensatordielektrikum 6 bedeckt hierbei in gleicher Weise die Seitenwände der Öffnung O sowie eine Hauptoberfläche des zweiten Zwischendielektrikums 4.

Als Materialien für das Kondensatordielektrikum 6 können beispielsweise Si₃N₄, Al₂O₃, HfO₂, ZrO₂ oder ONO-Schichtfolgen (Oxid-Nitrid-Oxid) konformal, d.h. mit gleicher Schichtdicke abgeschieden werden. Auf Grund der an den Seitenwänden der Öffnung O hochgezogenen Schicht für das Kondensatordielektrikum 6 ergeben sich verlängerte Leckstrompfade LS, die wiederum einen Leckstrom der MIM-Kapazität verringern. Durch die Höhe des zweiten Zwischendielektrikums 4 bzw. dessen Dicke wird die Länge des Leckstrompfades und somit auch der Leckstrom von der ersten Kondensatorelelktrode E1 bzw. der Diffusions-Barrierenschicht 5 zur zweiten Kondensatorelektrode E2 beeinflusst.

Gemäß Figur 1D wird nachfolgend ein ganzflächiges, konformales Ausbilden einer zweiten elektrisch leitenden Diffusions-Barrierenschicht 7 an der Oberfläche des Kondensatordielektrikums 6 als zweite Kondensatorelektrode E2 durchgeführt. Diese zweite elektrisch leitende Diffusions-Barrierenschicht 7 weist hierbei eine Schichtdicke auf, die wesentlich dicker ist als die erste elektrisch leitende Diffusions-Barrierenschicht 5, wobei sie jedoch nicht größer sein sollte als die verbleibende Tiefe der Öffnung O. Vorzugsweise ist sie kleiner als eine halbe Schichtdicke des zweiten Zwischendielektrikums 4, womit anschließend noch ausreichend Platz für ein drittes Zwischendielektrikum 9 ist.

Genauer gesagt kann mittels eines CVD-, ALD- oder PVD-Verfahrens (PVD, Physical Vapor Deposition) eine mindestens 10 nm dicke elektrisch leitende zweite Diffusions-Barrierenschicht 7 ausgebildet werden, deren Dicke jedoch nicht größer ist als die Dicke des zweiten Zwischendielektrikums 4 und somit kleiner 2-3F ist. Als Materialien für die zweite elektrisch leitende Diffusions-Barrierenschicht 7 können beispielsweise Ta, Ti, TaN und/oder TiN abgeschieden werden.

Optional kann gemäß Figur 1D ferner eine zweite elektrisch isolierende Diffusions-Barrierenschicht 8 als Ätzstoppschicht an der Oberfläche der nur aus der zweiten elektrisch leitenden Diffusions-Barrierenschicht 7 bestehenden zweiten Kondensatorelektrode E2 ausgebildet werden, wobei vorzugsweise das gleiche Material verwendet wird wie für die erste elektrisch isolierende Diffusions-Barrierenschicht 3.

Bei Verwendung dieser vorzugsweise gleichartigen optionalen Diffusions-Barrierenschichten 3 und 8 kann insbesondere bei einer nachfolgend durchzuführenden Kontaktierung sowohl für den MIM-Kondensator als auch für die Leitbahn L ein gleiches Verfahren durchgeführt werden, wodurch sich die Herstellungskosten wiederum wesentlich verringern. Wie die erste elektrisch isolierende Diffusions-Barrierenschicht 3 besteht demzufolge auch die Schicht 8 vorzugsweise aus Si₃N₄, SiC, SiCN oder einem Low-k-Material.

Weiterhin wird gemäß Figur 1D ein drittes Zwischendielektrikum 9 auf der zweiten Kondensatorelektrode E2 oder, sofern vorhanden, auf der zweiten elektrisch isolierenden Diffusions-Barrierenschicht 8 aufgebracht, wobei eine Dicke derart gewählt ist, dass die Öffnung O nunmehr vollständig aufgefüllt ist. Wiederum kann auch das dritte Zwischendielektrikum 9 aus einem Low-k-Material oder einem Oxid (Silan, TEOS) bestehen.

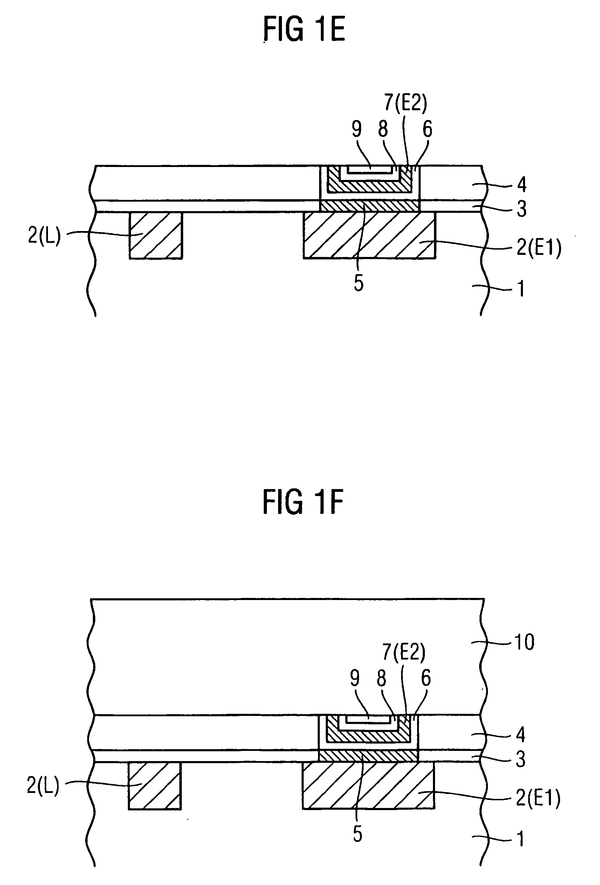

Gemäß Figur 1E wird nachfolgend ein Planarisieren (zum Strukturieren von zumindest dem Kondensatordielektrikum und der zweiten Kondensatorelektrode) vorzugsweise mittels eines CMP-Verfahrens (CMP, Chemical Mechanical Polishing) durchgeführt, wobei das Planarisieren erst bei Erreichen des zweiten Zwischendielektrikums 4 angehalten wird. Es sind daher mehrere CMP-Schritte nötig, um das dritte Zwischendielektrikum 9, die zweite elektrisch isolierende Diffusions-Barrierenschicht 8, die zweite Kondensatorelektrode E2 und das Kondensatordielektrikum 6 des MIM-Kondensators zu entfernen.

Gemäß Figur 1F wird nunmehr über den Leitbahnen L bzw. dem MIM-Kondensator ein weiteres Zwischendielektrikum 10 für die Kontaktvias oder beim Dual-Damascene-Verfahren für die Kontaktvias und weitere Leitbahnen ausgebildet. Genauer gesagt wird an der planarisierten Oberfläche gemäß Figur 1E das weitere Zwischendielektrikum 10 abgeschieden, welches insbesondere für ein bevorzugtes Dual-Damascene-Verfahren eine Vielzahl von Dielektrikumschichten für die auszubildenden Kontaktvias und Gräben bzw. Leitbahnen aufweist.

Anschließend können mittels herkömmlicher Lithographie die Kontaktlöcher KL sowie die zugehörigen Kontaktvias zum Anschließen der Leitbahn L und der zweiten Kondensatorelektrode E2 geätzt werden.

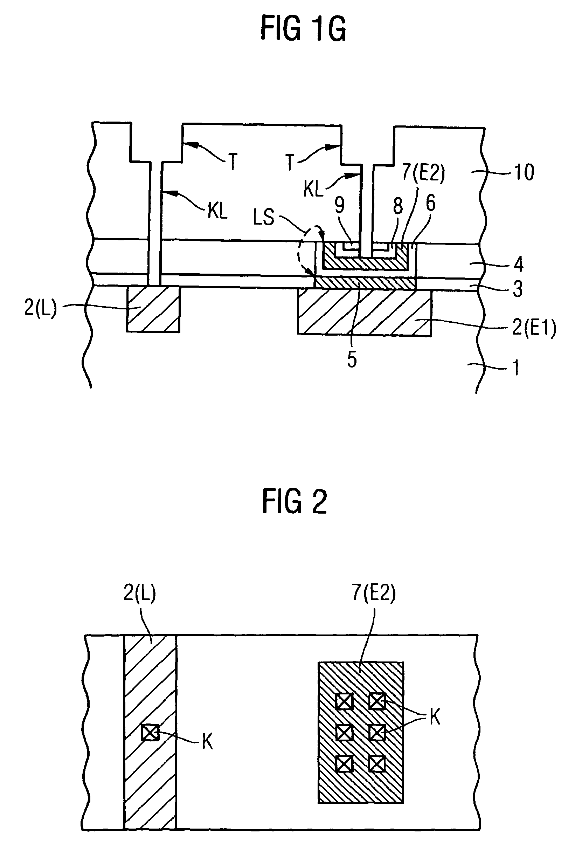

Gemäß Figur 1G wird vorzugsweise ein Dual-Damascene-Verfahren durchgeführt, wobei zunächst ein Graben T für jeweilige weitere Leitbahnen und anschließend ein Kontaktloch KL zum Kontaktieren der darunter liegenden Leitbahn L oder der zweiten Kondensatorelektrode E2 geätzt wird. Da die zweite Kondensatorelektrode E2 nunmehr erstmalig direkt kontaktiert werden kann und somit zusätzliche Schutzschichten fehlen können, wie sie beispielsweise für Cu erforderlich sind, ergeben sich wesentliche Kosteneinsparungen.

Insbesondere können herkömmliche Dual-Damascene-Verfahren sowohl zum Kontaktieren der Leitbahnen L als auch der zweiten Kondensatorelektroden E2 durchgeführt werden. Bei Verwendung der optionalen elektrisch isolierenden Diffusions-Barrierenschichten 3 und 8, welche vorzugsweise gleiche Materialien aufweisen, kann das Herstellungsverfahren darüber hinaus weiter vereinfacht werden, da nunmehr für beide Kontaktstellen auch gleiche Ätzverfahren verwendet werden können.

Da gemäß der vorliegenden Erfindung die zweite Kondensatorelektrode E2 nunmehr ausschließlich aus einer elektrisch leitenden Diffusions-Barrierenschicht mit höherer Schichtdicke besteht, ergibt sich im Gegensatz zu MIM-Kondensatoren, welche beispielsweise Cu als Kondensatorelektroden verwenden, ein höherer Innenwiderstand.

Figur 2 zeigt eine vereinfachte Draufsicht zur Darstellung einer Kontaktierung gemäß dem Ausführungsbeispiel von Figur 1, wobei gleiche Bezugszeichen gleiche oder entsprechende Elemente bezeichnen wie in Figur 1, weshalb auf eine wiederholte Beschreibung nachfolgend verzichtet wird.

Gemäß Figur 2 kann ein erhöhter Innenwiderstand für die zweite Kondensatorelektrode E2 durch eine veränderte Kontaktierung zumindest teilweise ausgeglichen werden, wobei im Bereich der zweiten Kondensatorelektrode E2 eine Vielzahl von Kontaktvias K zum Kontaktieren der zweiten Kondensatorelektrode E2 in dem weiteren Zwischendielektrikum 10 ausgebildet sind. Zur weiteren Reduzierung der Herstellungskosten sind diese Kontaktvias K identisch mit den Kontaktvias K für die Leitbahnen L, weshalb eine Erhöhung der Anzahl von Kontaktvias K direkt proportional zu einer Erhöhung der Kontaktfläche für die zweite Kondensatorelektrode E2 ist und damit den Innenwiderstand der zweiten Kondensatorelektrode E2 verbessert.

Auf diese Weise erhält man einen MIM-Kondensator sowie ein zugehöriges Herstellungsverfahren mit stark verringerten Herstellungskosten, wobei nahezu unveränderte elektrische Eigenschaften (Leckstrom, extr. Defektdichte) vorliegen.

## Patentansprüche

1. MIM-Kondensator mit
einem ersten Zwischendielektrikum (1);
einer ersten Kondensatorelektrode (2, E1), die in der Oberfläche des ersten Zwischendielektrikums (1) ausgebildet ist; einem zweiten Zwischendielektrikum (4), das auf dem ersten Zwischendielektrikum (1) ausgebildet ist und eine Öffnung (O) zum Freilegen von zumindest einem Teil der ersten Kondensatorelektrode (2, E1) aufweist;
einer ersten elektrisch leitenden Diffusions-Barrierenschicht (5), die an der Oberfläche der durch die Öffnung (O) freigelegten ersten Kondensatorelektrode (2, E1) ausgebildet ist; einem Kondensatordielektrikum (6), das auf der Diffusions-Barrierenschicht (5) und den Seitenwänden der Öffnung (O) ausgebildet ist; und
einer zweiten Kondensatorelektrode (7, E2), die an der Oberfläche des Kondensatordielektrikums (6) ausgebildet ist, wobei die zweite Kondensatorelektrode (7, E2) nur eine zweite elektrisch leitende Diffusions-Barrierenschicht aufweist.

2. MIM-Kondensator nach Patentanspruch 1,
**dadurch gekennzeichnet, dass** eine elektrisch isolierende Diffusions-Barrierenschicht (8) an der Oberfläche der zweiten Kondensatorelektrode (7, E2) ausgebildet ist.

3. MIM-Kondensator nach Patentanspruch 1 oder 2,
**dadurch gekennzeichnet, dass** die zweite Kondensatorelektrode (7, E2) innerhalb dem zweiten Zwischendielektrikum (4) ausgebildet ist.

4. MIM-Kondensator nach einem der Patentansprüche 1 bis 3,
**dadurch gekennzeichnet, dass** die zweite Kondensatorelektrode (7, E2) eine Schichtdicke aufweist, die größer ist als die Schichtdicke der ersten Barrierenschicht (5) und kleiner ist als eine halbe Schichtdicke des zweiten Zwischendielektrikums (4).

5. MIM-Kondensator nach einem der Patentansprüche 1 bis 4,
**dadurch gekennzeichnet, dass** die zweite Kondensatorelektrode (7, E2) Ta, Ti, TaN und/oder TiN aufweist.

6. MIM-Kondensator nach einem der Patentansprüche 1 bis 5,
**dadurch gekennzeichnet, dass** zwischen dem ersten Zwischendielektrikum (1) und dem zweiten Zwischendielektrikum (4) eine weitere elektrisch isolierende Diffusions-Barrierenschicht (3) ausgebildet ist.

7. MIM-Kondensator nach einem der Patentansprüche 1 bis 6,
**dadurch gekennzeichnet, dass** die zweite Kondensatorelektrode (7, E2) über eine Vielzahl von Kontaktvias (K) kontaktiert ist.

8. MIM-Kondensator nach einem der Patentansprüche 1 bis 7,
**dadurch gekennzeichnet, dass** die erste elektrisch leitende Diffusions-Barrierenschicht (5) selbstjustiert auf der ersten Kondensatorelektrode (2, E1) ausgebildet ist.

9. MIM-Kondensator nach einem der Patentansprüche 1 bis 8,
**dadurch gekennzeichnet, dass** ein weiteres Zwischendielektrikum (10) für ein Dual-Damascene-Verfahren an der Oberfläche des zweiten Zwischendielektrikum (4) ausgebildet ist.

10. Verfahren zur Herstellung eines MIM-Kondensators mit den Schritten:
a) Ausbilden einer ersten Kondensatorelektrode (2, E1) in der planaren Oberfläche eines ersten Zwischendielektrikums (1),
b) Ausbilden eines zweiten Zwischendielektrikums (4) auf dem ersten Zwischendielektrikum (1) und der ersten Kondensatorelektrode (2, E1);
c) Ausbilden einer Öffnung (O) im zweiten Zwischendielektrikum (4) zum Freilegen von zumindest einem Teil der ersten Kondensatorelektrode (2, E1);
d) selektives Ausbilden einer ersten elektrisch leitenden Diffusions-Barrierenschicht (5) an der Oberfläche der durch die Öffnung (O) freigelegten ersten Kondensatorelektrode (2, E1);
e) Ganzflächiges Ausbilden eines Kondensatordielektrikums (6) an der Oberfläche der ersten elektrisch leitenden Diffusions-Barrierenschicht (5) und des zweiten Zwischendielektrikums (4);
f) ganzflächiges Ausbilden einer zweiten elektrisch leitenden Diffusions-Barrierenschicht (7) an der Oberfläche des Kondensatordielektrikums (6) als zweite Kondensatorelektrode (E2);
g) ganzflächiges Ausbilden eines dritten Zwischendielektrikums (9) auf der zweiten Kondensatorelektrode (7, E2); und
h) Durchführen einer Planarisierung bis zum zweiten Zwischendielektrikum (4).

11. Verfahren nach Patentanspruch 10,
**dadurch gekennzeichnet, dass** vor Schritt b) eine erste elektrisch isolierende Diffusions-Barrierenschicht (3) an der Oberfläche des ersten Zwischendielektrikums (1) und der ersten Kondensatorelektrode (2, E1) ausgebildet wird; und
in Schritt c) die Öffnung (O) ferner in dieser isolierenden Diffusions-Barrierenschicht (3) ausgebildet wird.

12. Verfahren nach Patentanspruch 10 oder 11,
**dadurch gekennzeichnet, dass** in Schritt d) ein stromloses Abscheideverfahren in einem nass-chemischem Bad durchgeführt wird.

13. Verfahren nach einem der Patentansprüche 10 bis 12,
**dadurch gekennzeichnet, dass** in Schritt e) als Kondensatordielektrikum (6) ein High-k-Dielektrikum mit einer Dicke von 2 bis 50 nm abgeschieden wird.

14. Verfahren nach einem der Patentansprüche 10 bis 13,
**dadurch gekennzeichnet, dass** in Schritt f) die zweite Kondensatorelektrode (E2) mit einer Schichtdicke ausgebildet wird, die größer ist als die Schichtdicke der ersten Diffusions-Barrierenschicht (5) und kleiner ist als eine halbe Schichtdicke des zweiten Zwischendielektrikums (4).

15. Verfahren nach einem der Patentansprüche 10 bis 14, **dadurch gekennzeichnet, dass** in Schritt f) Ta, Ti, TaN und/oder TiN abgeschieden wird.

16. Verfahren nach einem der Patentansprüche 10 bis 15, **dadurch gekennzeichnet, dass** vor Schritt g) eine zweite elektrisch isolierende Diffusions-Barrierenschicht (8) an der Oberfläche der zweiten Kondensatorelektrode (7, E2) ausgebildet wird.

17. Verfahren nach einem der Patentansprüche 10 bis 16,
**dadurch gekennzeichnet, dass** in Schritt h) ein CMP-Verfahren durchgeführt wird.

18. Verfahren nach einem der Patentansprüche 10 bis 17,
**gekennzeichnet durch** den weiteren Schritt i) Ausbilden eines weiteren Zwischendielektrikums (10) für ein Dual-Damascene-Verfahren an der planarisierten Oberfläche.

19. Verfahren nach Patentanspruch 18,
**gekennzeichnet durch** den weiteren Schritt j) Ausbilden einer Vielzahl von Kontaktvias (K) in dem weiteren Zwischendielektrikum (10) zum Kontaktieren der zweiten Kondensatorelektrode (E2).

20. Verfahren nach Patentanspruch 19,
**dadurch gekennzeichnet, dass** ferner eine Leitbahn (L) in der planarisierten Oberfläche des ersten Zwischendielektrikums (1) ausgebildet ist; und
in Schritt j) gleichzeitig Kontaktvias (K) zum Kontaktieren der Leitbahn (L) ausgebildet werden.

## Claims

1. MIM capacitor with
a first intermediate dielectric (1);
a first capacitor electrode (2, E1), which is formed in the surface of the first intermediate dielectric (1);
a second intermediate dielectric (4), which is formed on the first intermediate dielectric (1) and has an opening (O) for exposing at least part of the first capacitor electrode (2, E1);
a first electrically conducting diffusion barrier layer (5), which is formed on the surface of the first capacitor electrode (2, E1) exposed by the opening (O);
a capacitor dielectric (6), which is formed on the diffusion barrier layer (5) and the side walls of the opening (O); and
a second capacitor electrode (7, E2), which is formed on the surface of the capacitor dielectric (6),
the second capacitor electrode (7, E2) comprising only a second electrically conducting diffusion barrier layer.

2. MIM capacitor according to Patent Claim 1, **characterized in that** an electrically insulating diffusion barrier layer (8) is formed on the surface of the second capacitor electrode (7, E2).

3. MIM capacitor according to Patent Claim 1 or 2, **characterized in that** the second capacitor electrode (7, E2) is formed within the second intermediate dielectric (4).

4. MIM capacitor according to one of Patent Claims 1 to 3, **characterized in that** the second capacitor electrode (7, E2) has a layer thickness which is greater than the layer thickness of the first barrier layer (5) and less than half the layer thickness of the second intermediate dielectric (4).

5. MIM capacitor according to one of Patent Claims 1 to 4, **characterized in that** the second capacitor electrode (7, E2) comprises Ta, Ti, TaN and/or TiN.

6. MIM capacitor according to one of Patent Claims 1 to 5, **characterized in that** a further electrically insulating diffusion barrier layer (3) is formed between the first intermediate dielectric (1) and the second intermediate dielectric (4).

7. MIM capacitor according to one of Patent Claims 1 to 6, **characterized in that** the second capacitor electrode (7, E2) is contacted by means of a multiplicity of contact vias (K).

8. MIM capacitor according to one of Patent Claims 1 to 7, **characterized in that** the first electrically conducting diffusion barrier layer (5) is formed in a self-adjusting manner on the first capacitor electrode (2, E1).

9. MIM capacitor according to one of Patent Claims 1 to 8, **characterized in that** a further intermediate dielectric (10) for a dual damascene process is formed on the surface of the second intermediate dielectric (4).

10. Method for producing an MIM capacitor with the steps of:
a) forming a first capacitor electrode (2, E1) in the planar surface of a first intermediate dielectric (1);
b) forming a second intermediate dielectric (4) on the first intermediate dielectric (1) and the first capacitor electrode (2, E1);
c) forming an opening (O) in the second intermediate dielectric (4) for exposing at least part of the first capacitor electrode (2, E1);
d) selectively forming a first electrically conducting diffusion barrier layer (5) on the surface of the first capacitor electrode (2, E1) exposed by the opening (O);
e) forming a capacitor dielectric (6) over the full surface area on the surface of the first electrically conducting diffusion barrier layer (5) and the second intermediate dielectric (4);
f) forming a second electrically conducting diffusion barrier layer (7) over the full surface area on the surface of the capacitor dielectric (6) as the second capacitor electrode (E2);
g) forming a third intermediate dielectric (9) over the full surface area on the second capacitor electrode (7, E2); and
h) carrying out a planarization down to the second intermediate dielectric (4).

11. Method according to Patent Claim 10, **characterized in that**, before step b), a first electrically insulating diffusion barrier layer (3) is formed on the surface of the first intermediate dielectric (1) and the first capacitor electrode (2, E1); and, in step c), the opening (O) is also formed in this insulating diffusion barrier layer (3).

12. Method according to Patent Claim 10 or 11, **characterized in that**, in step d), an electroless depositing process is carried out in a wet-chemical bath.

13. Method according to one of Patent Claims 10 to 12, **characterized in that**, in step e), a high-k dielectric is deposited with a thickness of from 2 to 50 nm as the capacitor dielectric (6).

14. Method according to one of Patent Claims 10 to 13, **characterized in that**, in step f), the second capacitor electrode (E2) is formed with a layer thickness which is greater than the layer thickness of the first diffusion barrier layer (5) and less than half the layer thickness of the second intermediate dielectric (4).

15. Method according to one of Patent Claims 10 to 14, **characterized in that**, in step f), Ta, Ti, TaN and/or TiN is deposited.

16. Method according to one of Patent Claims 10 to 15, **characterized in that**, before step g), a second electrically insulating diffusion barrier layer (8) is formed on the surface of the second capacitor electrode (7, E2).

17. Method according to one of Patent Claims 10 to 16, **characterized in that**, in step h), a CMP process is carried out.

18. Method according to one of Patent Claims 10 to 17, which comprises the further step i) of forming a further intermediate dielectric (10) for a dual damascene process on the planarized surface.

19. Method according to Patent Claim 18, which comprises the further step j) of forming a multiplicity of contact vias (K) in the further intermediate dielectric (10) for contacting the second capacitor electrode (E2).

20. Method according to Patent Claim 19, **characterized in that** an interconnect (L) is also formed in the planarized surface of the first intermediate dielectric (1); and,
in step j), at the same time contact vias (K) are formed for contacting the interconnect (L).

## Revendications

1. Condensateur MIM comprenant
un premier diélectrique (1) intermédiaire ;
une première électrode (2, E1) de condensateur, qui est formée dans la surface du premier diélectrique (1) intermédiaire ;
un deuxième diélectrique (4) intermédiaire, qui est formé sur le premier diélectrique (1) intermédiaire et qui a une ouverture (0) pour la mise à nu d'au moins une partie de la première électrode (2, E1) de condensateur ;
une première couche (5) conductrice de l'électricité formant barrière à la diffusion, qui est formée à la surface de la première électrode (2, E1) de condensateur mise à nu par l'ouverture (0) ;
un diélectrique (6) de condensateur, qui est formé sur la couche (5) formant barrière de diffusion et sur les parois latérales de l'ouverture (O) ; et
une deuxième électrode (7, E2) de condensateur, qui est formée à la surface du diélectrique (6) de condensateur, la deuxième électrode (7, E2) de condensateur n'ayant qu'une deuxième couche conductrice de l'électricité formant barrière à la diffusion.

2. Condensateur MIM suivant la revendication 1,
**caractérisé en ce qu'**une couche (8) isolante du point de vue électrique et formant barrière à la diffusion est formée à la surface de la deuxième électrode (7, E2) de condensateur.

3. Condensateur MIM suivant la revendication 1 ou 2, **caractérisé en ce que** la deuxième électrode (7, E2) de condensateur est formée au sein du deuxième diélectrique (4) intermédiaire.

4. Condensateur MIM suivant l'une des revendications 1 à 3, **caractérisé en ce que** la deuxième électrode (7, E2) de condensateur a une épaisseur de couche qui est plus grande que l'épaisseur de couche de la première couche (5) formant barrière et plus petite que la moitié de l'épaisseur de couche du deuxième diélectrique (4) intermédiaire.

5. Condensateur MIM suivant l'une des revendications 1 à 4, **caractérisé en ce que** la deuxième électrode (7, E2) de condensateur comporte du Ta, du Ti, du TaN et/ou du TiN.

6. Condensateur MIM suivant l'une des revendications 1 à 5, **caractérisé en ce qu'**une autre couche (3) isolante du point de vue électrique et formant barrière de diffusion est formée entre le premier diélectrique (1) et le deuxième diélectrique (4) intermédiaire.

7. Condensateur MIM suivant l'une des revendications 1 à 6, **caractérisé en ce que** la deuxième électrode (7, E2) de condensateur est mise en contact par une pluralité de traversées (K) de contact.

8. Condensateur MIM suivant l'une des revendications 1 à 7, **caractérisé en ce que** la première couche (5) conductrice de l'électricité formant barrière de diffusion est formée de manière auto-alignée sur la première électrode (2, E1) de condensateur.

9. Condensateur MIM suivant l'une des revendications 1 à 8, **caractérisé en ce qu'**un autre diélectrique (10) intermédiaire pour un procédé damascène dual est formé à la surface du deuxième diélectrique (4) intermédiaire.

10. procédé de fabrication d'un condensateur MIM comprenant les stade :
a) on forme une première électrode (2, E1) de condensateur dans la surface planaire d'un premier diélectrique (1) intermédiaire ;
b) on forme un deuxième diélectrique (4) intermédiaire sur le premier diélectrique (1) intermédiaire et la première électrode (2, E1) de condensateur ;
c) on forme une ouverture (O) dans le deuxième diélectrique (4) intermédiaire pour mettre à nu au moins une partie de la première électrode (2, E1) de condensateur ;
d) on forme sélectivement une première couche (5) conductrice de l'électricité formant barrière de diffusion à la surface de la première électrode (2, E1) de condensateur mise à nu par l'ouverture (O) ;
e) on forme sur toute la surface un diélectrique (6) de condensateur à la surface de la première couche (5) conductrice de l'électricité formant barrière de diffusion et du deuxième diélectrique (4) intermédiaire ;
f) on forme sur toute la surface une deuxième couche (7) conductrice de l'électricité formant barrière de diffusion à la surface du diélectrique (6) de condensateur en tant que deuxième électrode (E2) de condensateur ;
g) on forme sur toute la surface un troisième diélectrique (9) intermédiaire sur la deuxième électrode (7, E2) de condensateur ; et
h) on effectue une planarisation jusqu'au deuxième diélectrique (4) intermédiaire.

11. Procédé suivant la revendication 10,
**caractérisé en ce que**
avant le stade b), on forme une première couche (3) isolante du point de vue électrique et formant barrière de diffusion à la surface du premier diélectrique (1) intermédiaire et de la première électrode (2, E1) de condensateur ; et
au stade c), on forme l'ouverture (0) plus loin dans cette couche (3) isolante et formant barrière de diffusion.

12. Procédé suivant la revendication 10 ou 11,
**caractérisé en ce que**, au stade d), on effectue un procédé de dépôt sans courant dans un bain chimique en voie humide.

13. Procédé suivant l'une des revendications 10 à 12,
**caractérisé en ce que**, au stade e), on dépose comme diélectrique (6) de condensateur un diélectrique à grand k ayant une épaisseur de 2 à 50 nm.

14. Procédé suivant l'une des revendications 10 à 13,
**caractérisé en ce que**, au stade f), on forme la deuxième électrode (E2) de condensateur en une épaisseur de couche, qui est plus grande que l'épaisseur de couche de la première couche (5) formant barrière de diffusion et qui est plus petite que la moitié de l'épaisseur de couche du deuxième diélectrique (4) intermédiaire.

15. Procédé suivant l'une des revendications 10 à 14,
**caractérisé en ce que**, au stade f), on dépose du Ta, du Ti, du TaN et/ou du TiN.

16. Procédé suivant l'une des revendications 10 à 15,
**caractérisé en ce que**, avant le stade g) on forme une deuxième couche (8) isolante du point de vue électrique et formant barrière de diffusion à la surface de la deuxième électrode (7, E2) de condensateur.

17. Procédé suivant l'une des revendications 10 à 16,
**caractérisé en ce que**, au stade h), on effectue un procédé CMP.

18. Procédé suivant l'une des revendications 10 à 17,
**caractérisé par** le stade i) supplémentaire, dans lequel on forme un autre diélectrique (10) intermédiaire pour un procédé damascène dual sur la surface planarisée.

19. Procédé suivant la revendication 18,
**caractérisé par** le stade i) supplémentaire, dans lequel on forme une pluralité de traversées (K) de contact dans l'autre diélectrique (10) intermédiaire pour la mise en contact de la deuxième électrode (E2) de condensateur.

20. Procédé suivant la revendication 19,
**caractérisé en ce qu'**on forme, en outre, une piste (L) conductrice dans la surface planarisée du premier diélectrique (1) intermédiaire ; et
au stade j), on forme en même temps des traversées (K) de contact pour la mise en contact de la piste (L) conductrice.
